# EUROPEAN PATENT SPECIFICATION

(11) **EP 2 779 399 B1**
(45) Date of publication and mention of the grant of the patent: **20.07.2016**
(21) Application number: 14159410.1
(22) Date of filing: 13.03.2014
(51) Int. Cl.: H02M 3/158

(54) **Electromagnetic interference (EMI) reduction in interleaved power converter**
Reduzierung von elektromagnetischer Interferenz (EMI) in verschachteltem Stromwandler
Réduction d'interférence électromagnétique (EMI) dans un convertisseur de puissance entrelacé

(30) Priority: 15.03.2013 US 201313836241
(43) Date of publication of application: 17.09.2014
(73) Proprietor: Hamilton Sundstrand Corporation, Windsor Locks, CT 06096-1010 (US)
(72) Inventor: White, Adam M, Belvidere, IL Illinois 61008 (US); Mustansir, Kheraluwala, Lake Zurich, IL Illinois 60047 (US); Davidson, Steven A., Pecatonica, IL Illinois 61063 (US)
(74) Representative: Hughes, Andrea Michelle

(56) References cited:
- WO-A2-2007/103651
- US-A- 6 101 109
- US-A1- 2006 120 121
- US-A1- 2007 242 489

## Description

### BACKGROUND

The present invention relates to electromagnetic interference (EMI) noise mitigation for interleaved power converters.

Switching power converters are often used to convert an alternating current (AC) voltage into a direct current (DC) voltage, or to convert a DC voltage into an AC voltage. One example of such a power converter is a two-level (2L) converter, which is able to synthesize two node voltages ("levels") at a phase terminal. These converters typically use pulse-width modulation (PWM) at a fixed switching frequency in order to approximate a desired continuous waveform. PWM is known to cause distortions in the output waveform, which are typically undesirable. In WO 2007/103651, an interleaved soft switching bridge power converter is disclosed that includes switching poles operated to reduce turn-on switching losses. The switching poles are arranged into bridge circuits and operated in an interleaved manner. In US 6,101,109, an unlimited voltage static power converter is disclosed that includes an array of multi-level phase drivers. Each phase driver includes H-bridge power modules in which the H-bridges are connected into a three-dimensional multi-level, multi-phase array to permit use in high power systems.

### SUMMARY

A power converter system is disclosed herein that includes an interleaved power converter having a plurality of parallel-connected phase legs between DC terminals and an AC terminal. A plurality of parallel-connected inductors are each connected to one of the plurality of parallel-connected phase legs to provide a summed output of the parallel-connected phase legs to the AC terminal. A controller generates PWM signals used to control the state of each of the plurality of phase legs by comparing a carrier signal to a reference signal, wherein a period of the carrier signal is randomly varied from a nominal period.

A controller is disclosed herein for providing PWM control of an interleaved power converter having at least a first phase leg and a second phase leg. The controller includes a random value generator that randomly generates values within a pre-determined range, a summer that adds the values generated by the random number generator to a nominal value to define a period of a carrier signal, a carrier signal generator that generates a first carrier signal having a period defined by the output of the summer, wherein the period of the carrier signal is varied from a nominal period by the addition of the random value provided by the random value generator to the nominal value, a phase adjuster that generates a second carrier signal shifted in phase related to the first carrier signal, a first comparator that compares the first carrier signal to a reference signal to generate first PWM signals used to control a state of the first phase leg of the interleaved power converter, and a second comparator that compares the second carrier signal to the reference signal to generate second PWM signals used to control a state of the second phase leg of the interleaved power converter.

A method of reducing EMI of an interleaved power converter is disclosed herein. The method includes generating random values, periodically adjusting a nominal value with a generated random value to determine a randomized period of a first carrier signal, generating the first carrier signal having the randomized period, generating a second carrier signal that is phase shifted relative to the first carrier signal, generating first PWM signals used to control a state of a first phase leg of the interleaved power converter by comparing the first carrier signal to a reference signal, generating second PWM signals used to control a state of a second phase leg of the interleaved power converter by comparing the second carrier signal to the reference signal, and providing the first and second PWM signals to the interleaved power converter.

### BRIEF DESCRIPTION OF THE DRAWINGS

FIG. 1 is a schematic diagram of an interleaved power converter system.
FIG. 2 is a functional block diagram illustrating functions performed by a controller in generating pulse width modulation (PWM) control signals provided to the interleaved power converter system.
FIG. 3 is a waveform diagram illustrating carrier signals generated according to an embodiment of the present invention.
FIG. 4 is a waveform diagram illustrating carrier signals generated according to another embodiment of the present invention.
FIG. 5 is a waveform diagram illustrating carrier signals generated according to a further embodiment of the present invention.

### DETAILED DESCRIPTION

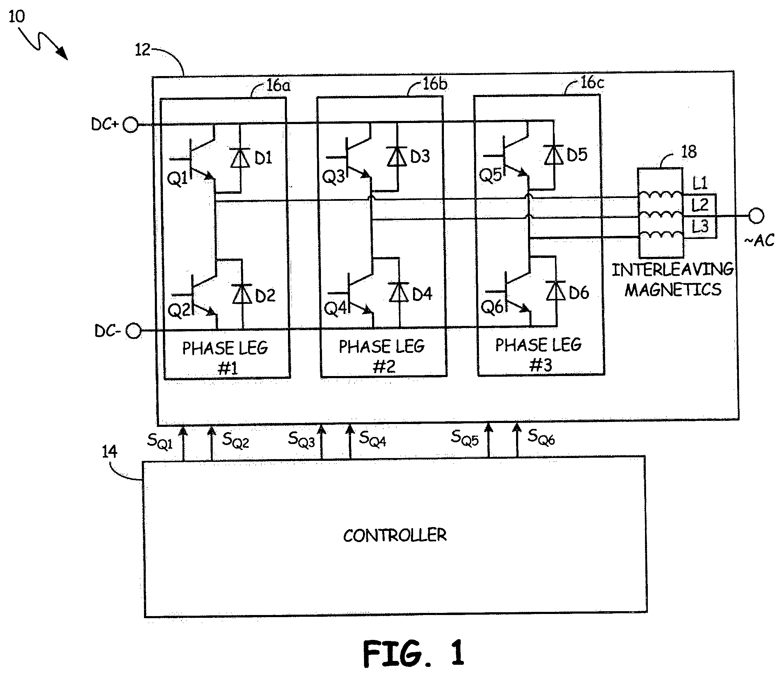

FIG. 1 is a schematic diagram of an embodiment of an interleaved power converter system 10, which includes two-level (2L) converter 12 and controller 14. Two-level converter 12 includes interleaved phase legs 16a, 16b and 16c and interleaving magnetics 18 connected between DC tenninals DC+ and DC- and AC terminal AC~. Phase leg 16a includes transistors Q1 and Q2 and diodes D1 and D2, phase leg 16b includes transistors Q3 and Q4 and diodes D3 and D4, and phase leg 16c includes transistors Q5 and Q6 and diodes D5 and D6. Interleaving magnetics 18 include inductors L1, L2 and L3 connected to respective phase legs 16a, 16b and 16c.

Each of phase legs 16a, 16b and 16c is able to synthesize two node voltages ("levels") at respective phase for connection to AC terminal AC~. For example, referring to phase leg 16a, transistor Q1 is turned on (with transistor Q2 turned off) to synthesize an output node voltage equal to the DC+ node voltage, and transistor Q2 is turned on (with transistor Q1 turned off) in order to synthesize an output node voltage equal to the DC- node voltage. Phase leg 16a is able to use pulse-width modulation (PWM) at a fixed switching frequency to control the switching of transistors Q1 and Q2 in order to approximate a desired continuous waveform. The same is true for phase legs 16b and 16c, with each of the phase legs being offset from one another by a phase delay. The pulse-width modulated switching signals are shown as signals S_{Q1}, S_{Q2}, S_{Q3}, S_{Q4}, S_{Q5} and S_{Q6} output from controller 14 to two-level converter 12.

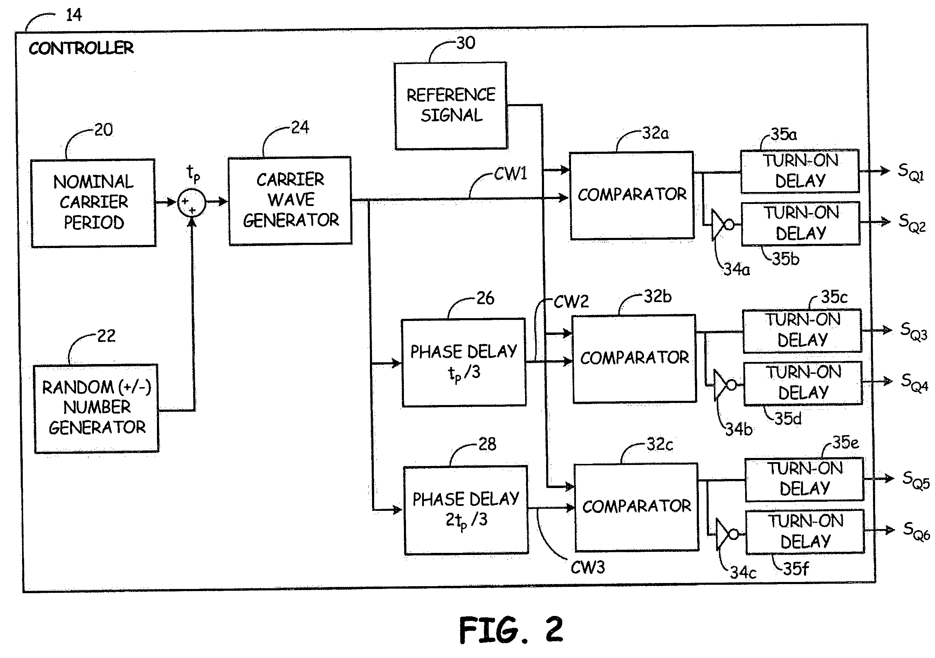

PWM-created waveforms are subject to distortion - that is, a true continuous waveform is typically not achieved. The distortion of the output waveform from a true continuous waveform creates electromagnetic interference (EMI). Interleaving provides the advantage of reducing EMI at the output of the combined parallel phase legs 16a, 16b and 16c. In addition, the peak amplitudes of the EMI/distortions of the output waveform in the frequency domain may be further reduced by adding random fractional variation to the PWM switching frequency. An interleaved power converter system controller that employs random fractional variation of a carrier signal in order to minimize EMI in the output waveform is shown in FIG. 2.

FIG. 2 is a functional block diagram illustrating functions performed by controller 14 in generating PWM control signals S_{Q1}, SQ2, S_{Q3}, S_{Q4}, S_{Q5} and S_{Q6} provided to the interleaved power converter system 10 (FIG. 1). A carrier wave having period tp is generated by summing nominal carrier period 20 and an output of random number generator 22 (which generates appropriately range-limited random values that may be positive or negative in an exemplary embodiment). Carrier wave generator 24 generates carrier wave CW1 having period tₚ. In addition, carrier wave CW2 is generated by applying phase delay 26 (a delay of tp/3 in the depicted embodiment) to the output of carrier wave generator 24, and carrier wave CW3 is generated by applying phase delay 28 (a delay of 2tₚ/3 in the depicted embodiment) to the output of carrier wave generator 24. Phase delay between each successive carrier wave is tₚ/n_{c}, wherein n_{c} is the number of interleaved phase legs. Low frequency reference signal 30, such as a sinusoidal voltage reference signal in an exemplary embodiment, is compared to high frequency carrier signals CW1, CW2 and CW3, which may be triangular wave signals in an exemplary embodiment, by comparators 32a, 32b and 32c. The output of comparator 32a, delayed by turn-on delay 35a, provides switching control signal S_{Q1}, and the output of comparator 32a, inverted by inverter 34a and delayed by turn-on delay 35b, provides switching control signal S_{Q2}. Similarly, the output of comparator 32b, delayed by turn-on delay 35c, provides switching control signal S_{Q3}, and the output of comparator 32b, inverted by inverter 34b and delayed by turn-on delay 35d, provides switching control signal S_{Q4}. Likewise, output of comparator 32c, delayed by turn-on delay 35e, provides switching control signal S_{Q5}, and the output of comparator 32c, inverted by inverter 34c and delayed by turn-on delay 35f, provides switching control signal S_{Q6}. Switching control signals S_{Q1}, S_{Q2}, S_{Q3}, S_{Q4}, S_{Q5} and S_{Q6} are used to turn on and off transistors Q1, Q2, Q3, Q4, Q5 and Q6 (FIG. 1), respectively.

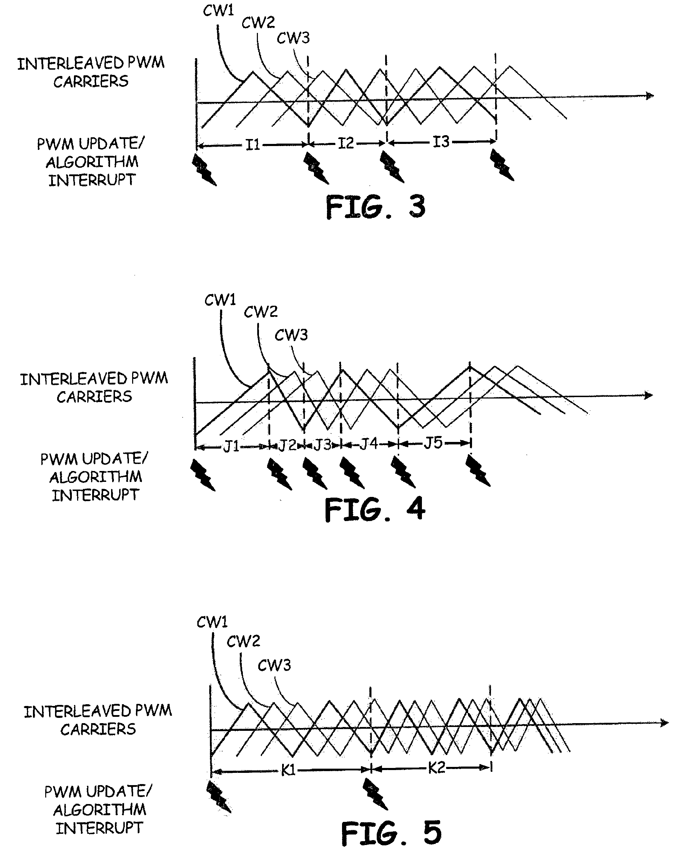

By applying phase shifts between high frequency carrier signals CW1, CW2 and CW3 used for each phase leg 16a, 16b and 16c (FIG. 1), certain frequencies of EMI can be eliminated or significantly reduced. Additional EMI can occur in high frequency components of the AC node voltage (at terminal AC~, FIG. 1) at a multitude of discrete frequencies in the infinite frequency set of n(1/t_{c}) +/- m(1/tᵣ), where n and m are integers, t_{c} is the nominal carrier period and tᵣ is the reference signal period. This EMI is mitigated by the utilization of random number generator 22. Specifically, random number generator 22 is used to make an adjustment to nominal carrier period 20 (t_{c}), such as by adding a positive or negative random value, which results in the high frequency EMI components of the output waveform being spread (or smeared) from the discrete frequencies at which high peak magnitudes of EMI would otherwise occur in a carrier-based PWM scheme, to a band of frequencies spread around these discrete frequencies with reduced peak magnitudes of EMI. This concept is illustrated graphically in the waveform diagrams of FIGS. 3, 4 and 5.

FIG. 3 is a waveform diagram illustrating carrier signals CW1, CW2 and CW3 generated according to an embodiment of the present invention. As shown, carrier signal CW1 has a first period in the first time interval I1, has a second period in the second time interval 12, and has a third period in the third time interval I3. These varying, randomized periods are set in an exemplary embodiment by adding/subtracting a random number (generated by random number generator 22, FIG. 2) to/from a nominal carrier signal period. A new randomized period is generated in this embodiment at each full period of carrier signal CW1, so that each of time intervals I1, I2 and I3 begins after a full carrier signal period has been completed for carrier signal CW1. Carrier signal CW2 is delayed from carrier signal CW1 by one-third of the carrier signal period, and carrier signal CW3 is delayed from carrier signal CW1 by two-thirds of the carrier signal period.

FIG. 4 is a waveform diagram illustrating carrier signals CW1, CW2 and CW3 generated according to another embodiment of the present invention. As shown, carrier signal CW1 has varying, randomized periods in each of time intervals J1, J2, J3, J4 and J5. These varying, randomized periods are set in an exemplary embodiment by adding/subtracting a random number (generated by random number generator 22, FIG. 2) to/from a nominal carrier signal period. A new randomized period is generated in this embodiment at each half period of carrier signal CW1, so that each of time intervals J1, J2, J3, J4 and J5 begins after a half carrier signal period has been completed for carrier signal CW1. Carrier signal CW2 is delayed from carrier signal CW1 by one-third of the carrier signal period, and carrier signal CW3 is delayed from carrier signal CW1 by two-thirds of the carrier signal period.

FIG. 5 is a waveform diagram illustrating carrier signals CW1, CW2 and CW3 generated according to a further embodiment of the present invention. As shown, carrier signal CW1 has varying, randomized periods in each of time intervals K1 and K2. These varying, randomized periods are set in an exemplary embodiment by adding/subtracting a random number (generated by random number generator 22, FIG. 2) to/from a nominal carrier signal period. A new randomized period is generated in this embodiment after two full periods of carrier signal CW1, so that each of time intervals K1 and K2 begins after two full carrier signal periods have been completed for carrier signal CW1. Carrier signal CW2 is delayed from carrier signal CW1 by one-third of the carrier signal period, and carrier signal CW3 is delayed from carrier signal CW1 by two-thirds of the carrier signal period.

In the embodiments shown in FIGS. 3-5, the variation of the carrier signal period results in a spreading or smearing of the high frequency EMI noise components of the AC output voltage from the discrete frequencies where these EMI noise components have high peak magnitudes, so that the high frequency EMI noise components are seen across a wide band of frequencies with reduced peak amplitudes.

While examples of the present invention have been shown in FIGS. 3-5 where a new randomized period is generated to adjust the period of the carrier signals at full, half, and two period intervals, it should be understood that other timing arrangements for the generation of a new random number to adjust the carrier signal period are possible and contemplated herein, such as other fractions or multiples of the carrier signal period, based on a timer that is unrelated to the carrier signal period, or other arrangements.

While examples of the present invention have been shown and described herein for an interleaved power converter having three phase legs, it should be understood that any number of interleaved phase legs may be employed utilizing the principles and concepts described herein.

### Discussion of Possible Embodiments

The following are non-exclusive descriptions of possible embodiments of the present invention.

A power converter system includes, among other things, an interleaved power converter having a plurality of parallel-connected phase legs connected between DC terminals and an AC terminal, a plurality of parallel-connected inductors each connected to one of the plurality of parallel-connected phase legs to provide a summed output of the parallel-connected phase legs to the AC terminal, and a controller that generates PWM signals used to control the state of each of the plurality of phase legs by comparing a carrier signal to a reference signal, wherein a period of the carrier signal is randomly varied from a nominal period.

The power converter system of the preceding paragraph can optionally include, additionally and/or alternatively, any one or more of the following features, configurations and/or additional components:

The controller includes a random number generator that generates random values, within a pre-determined numeric range, that vary the period of the carrier signal from the nominal period.

The random values generated by the random number generator vary the period of the carrier signal at half-cycle intervals of the carrier signal.

The random values generated by the random number generator vary the period of the carrier signal at full-cycle intervals of the carrier signal.

The random values generated by the random number generator vary the period of the carrier signal at multiple-cycle intervals of the carrier signal.

The plurality of parallel-connected phase legs includes a first phase leg, a second phase leg, and a third phase leg.

The plurality of parallel-connected inductors includes a first inductor connected between the first phase leg and the AC terminal, a second inductor connected between the second phase leg and the AC terminal, and a third inductor connected between the third phase leg and the AC terminal.

The carrier signal is divided into a first carrier signal, a second carrier signal phase shifted relative to the first carrier signal, and a third carrier signal phase shifted relative to the first and second carrier signals.

A controller for providing pulse-width modulation control of an interleaved power converter having at least a first phase leg and a second phase leg includes, among other things, a random value generator that randomly generates values, a summer that adds the values generated by the random value generator to a nominal value to define a period of a carrier signal, a carrier signal generator that generates a first carrier signal having a period defined by the output of the summer, wherein the period of the carrier signal is varied from a nominal period by the addition of the random value provided by the random value generator to the nominal value, a phase adjustor that generates a second carrier signal shifted in phase relative to the first carrier signal, a first comparator that compares the first carrier signal to a reference signal to generate first pulse-width modulated (PWM) signals used to control a state of the first phase leg of the interleaved power converter, and a second comparator that compares the second carrier signal to the reference signal to generate second PWM signals used to control a state of the second phase leg of the interleaved power converter.

The controller of the preceding paragraph can optionally include, additionally and/or alternatively, any one or more of the following features, configurations and/or additional components:

The random value generator randomly generates positive and negative values.

The output of the random value generator is range-limited such that the random values may not exceed minimum and maximum limits.

The period of the first carrier signal is modified once per half-cycle of the first carrier signal.

The period of the first carrier signal is modified once per cycle of the first carrier signal.

The period of the first carrier signal is modified once per multiple cycles of the first carrier signal.

The first and second PWM signals each comprise two complementary PWM signals.

A method of reducing electromagnetic interference (EMI) of an interleaved power converter includes, among other things, generating random values, periodically adjusting a nominal value with a generated random value to determine a randomized period of a first carrier signal, generating the first carrier signal having the randomized period, generating a second carrier signal that is phase shifted relative to the first carrier signal, generating first pulse-width modulation (PWM) signals used to control a state of a first phase leg of the interleaved power converter by comparing the first carrier signal to a reference signal, generating second pulse-width modulation (PWM) signals used to control a state of a second phase leg of the interleaved power converter by comparing the second carrier signal to the reference signal, and providing the first and second PWM signals to the interleaved power converter.

The method of the preceding paragraph can optionally include, additionally and/or alternatively, any one or more of the following features, configurations and/or additional steps:

The random values are positive and negative values, and adjusting the nominal value with the generated random value comprises adding the generated random value to the nominal value to determine the randomized period of the first carrier signal.

The output of the random value generator is range-limited such that the random values may not exceed minimum and maximum limits.

The period of the first carrier signal is modified once per half-cycle of the first carrier signal.

The period of the first carrier signal is modified once per cycle of the first carrier signal.

The period of the first carrier signal is modified once per multiple cycles of the first carrier signal.

The first and second PWM signals each comprise two complementary PWM signals.

While the invention has been described with reference to an exemplary embodiment(s), it will be understood by those skilled in the art that various changes may be made and equivalents may be substituted for elements thereof without departing from the scope of the invention. In addition, many modifications may be made to adapt a particular situation or material to the teachings of the invention without departing from the essential scope thereof. Therefore, it is intended that the invention not be limited to the particular embodiment(s) disclosed, but that the invention will include all embodiments falling within the scope of the appended claims.

## Claims

1. A controller for providing pulse-width modulation control of an interleaved power converter having at least a first phase leg and a second phase leg, the controller **characterised by**:
a random value generator (22) that randomly generates values;
a summer that adds the values generated by the random value generator to a nominal value to define a period of a carrier signal;
a carrier signal generator (24) that generates a first carrier signal having a period defined by the output of the summer, wherein the period of the carrier signal is varied from a nominal period by the addition of the random value provided by the random value generator to the nominal value;
a phase adjustor (26, 28) that generates a second carrier signal shifted in phase relative to the first carrier signal;
a first comparator (32a) that compares the first carrier signal to a reference signal to generate first pulse-width modulated (PWM) signals used to control a state of the first phase leg of the interleaved power converter; and
a second comparator (32b) that compares the second carrier signal to the reference signal to generate second PWM signals used to control a state of the second phase leg of the interleaved power converter.

2. The controller of claim 1, wherein the random value generator randomly generates positive and negative values.

3. The controller of claim 1 or 2, wherein the period of the first carrier signal is modified once per half-cycle of the first carrier signal, or once per cycle of the first carrier signal, or once per multiple cycles of the first carrier signal.

4. The controller of claim 1, 2 or 3, wherein the first and second PWM signals each comprise two complementary PWM signals.

5. A power converter system comprising:
an interleaved power converter (12) having a plurality of parallel-connected phase legs (16) connected between direct current (DC) terminals and an alternating current (AC) terminal;
a plurality of parallel-connected inductors (L1, L2, L3) each connected to one of the plurality of parallel-connected phase legs to provide a summed output of the parallel-connected phase legs to the AC terminal; and
a controller (14) as claimed in any preceding claim that generates pulse-width modulation (PWM) signals used to control the state of each of the plurality of phase legs by comparing the carrier signal to the reference signal.

6. The power converter system of claim 5, wherein the plurality of parallel-connected phase legs includes a first phase leg, a second phase leg, and a third phase leg.

7. The power converter system of claim 6, wherein the plurality of parallel-connected inductors includes a first inductor connected between the first phase leg and the AC terminal, a second inductor connected between the second phase leg and the AC terminal, and a third inductor connected between the third phase leg and the AC terminal.

8. The power converter system of claim 7, wherein the carrier signal is divided into a first carrier signal, a second carrier signal phase shifted relative to the first carrier signal, and a third carrier signal phase shifted relative to the first and second carrier signals.

9. A method of reducing electromagnetic interference (EMI) of an interleaved power converter, the method **characterised by**:
generating random values;
periodically adjusting a nominal value with a generated random value to determine a randomized period of a first carrier signal;
generating the first carrier signal having the randomized period;
generating a second carrier signal that is phase shifted relative to the first carrier signal;
generating first pulse-width modulation (PWM) signals used to control a state of a first phase leg of the interleaved power converter by comparing the first carrier signal to a reference signal;
generating second pulse-width modulation (PWM) signals used to control a state of a second phase leg of the interleaved power converter by comparing the second carrier signal to the reference signal; and
providing the first and second PWM signals to the interleaved power converter.

10. The method of claim 9, wherein the random values are positive and negative values, and adjusting the nominal value with the generated random value comprises adding the generated random value to the nominal value to determine the randomized period of the first carrier signal.

11. The method of claim 9, wherein the period of the first carrier signal is modified once per half-cycle of the first carrier signal, or once per cycle of the first carrier signal, or once per multiple cycles of the first carrier signal.

12. The method of claim 9, 10 or 11, wherein the first and second PWM signals each comprise two complementary PWM signals.

## Patentansprüche

1. Steuereinrichtung zum Bereitstellen von Pulsweitenmodulationssteuerung eines verschachtelten Leistungswandlers mit wenigstens einem ersten Phasenabschnitt und einem zweiten Phasenabschnitt, wobei die Steuereinrichtung **gekennzeichnet ist durch**:
einen Zufallswertgenerator (22), der zufällig Werte generiert;
einen Summierer, der die vom Zufallswertgenerator generierten Werte zu einem Nennwert addiert, um eine Periode eines Trägersignals zu definieren;
einen Trägersignalgenerator (24), der ein erstes Trägersignal mit einer Periode generiert, die von dem Ausgang des Summierers bestimmt wird, wobei die Periode des Trägersignals gegenüber einer Nennperiode **durch** Addieren des Zufallswerts, der von dem Zufallswertgenerator bereitgestellt wird, zu dem Nennwert variiert wird;
eine Phasenanpassungseinrichtung (26, 28), die ein zweites Trägersignal generiert, dessen Phase im Verhältnis zum ersten Trägersignal verschoben ist;
eine erste Vergleichseinrichtung (32a), die das Trägersignal mit einem Referenzsignal vergleicht, um erste Pulsweitenmodulations-(PWM)-Signale zu generieren, die zum Steuern eines Zustands des ersten Phasenabschnitts des verschachtelten Leistungswandlers verwendet werden; und
eine zweite Vergleichseinrichtung (32b), die das Trägersignal mit einem Referenzsignal vergleicht, um zweite PWM-Signale zu generieren, die zum Steuern eines Zustands des zweiten Phasenabschnitts des verschachtelten Leistungswandlers verwendet werden.

2. Steuereinrichtung nach Anspruch 1, wobei der Zufallswertgenerator zufällig positive und negative Werte generiert.

3. Steuereinrichtung nach Anspruch 1 oder 2, wobei die Periode des ersten Trägersignals einmal pro Halbzyklus des ersten Trägersignals oder einmal pro Zyklus des ersten Trägersignals oder einmal pro mehrere Zyklen des ersten Trägersignals modifiziert wird.

4. Steuereinrichtung nach Anspruch 1, 2 oder 3, wobei die ersten und zweiten PWM-Signale jeweils zwei komplementäre PWM-Signale umfassen.

5. Leistungswandlungssystem, umfassend:
einen verschachtelten Leistungswandler (12) mit einer Mehrzahl von parallel verbundenen Phasenabschnitten (16), die zwischen Gleichstrom-(DC)-Klemmen und einer Wechselstrom-(AC)-Klemme verbunden sind;
eine Mehrzahl von parallel verbundenen Induktoren (L1, L2, L3), die jeweils mit einem der Mehrzahl von parallel verbundenen Phasenabschnitten verbunden sind, um einen summierten Ausgang der parallel verbundenen Phasenabschnitte an die AC-Klemme bereitzustellen; und
eine Steuereinrichtung (14) nach einem der vorangehenden Ansprüche, die Pulsweitenmodulations-(PWM)-Signale generiert, die zum Steuern eines Zustands von jedem der Mehrzahl von Phasenabschnitten verwendet wird, indem sie das Trägersignal mit dem Referenzsignal vergleicht.

6. Leistungswandlungssystem nach Anspruch 5, wobei die Mehrzahl von parallel verbundenen Phasenabschnitten einen ersten Phasenabschnitt, einen zweiten Phasenabschnitt und einen dritten Phasenabschnitt beinhaltet.

7. Leistungswandlungssystem nach Anspruch 6, wobei die Mehrzahl von parallel verbundenen Induktoren einen ersten Induktor, der zwischen dem ersten Phasenabschnitt und der AC-Klemme verbunden ist, einen zweiten Induktor, der zwischen dem zweiten Phasenabschnitt und der AC-Klemme verbunden ist, und einen dritten Induktor beinhaltet, der zwischen dem dritten Phasenabschnitt und der AC-Klemme verbunden ist.

8. Leistungswandlungssystem nach Anspruch 7, wobei das Trägersignal in ein erstes Trägersignal, ein zweites Trägersignal, das im Verhältnis zum ersten Trägersignal phasenverschoben ist, und ein drittes Trägersignal, das im Verhältnis zum ersten und zweiten Trägersignal phasenverschoben ist, unterteilt ist.

9. Verfahren zum Reduzieren elektromagnetischer Interferenz (EMI) eines verschachtelten Leistungswandlers, wobei das Verfahren **gekennzeichnet ist durch**:
Generieren von Zufallswerten;
periodisches Anpassen eines Nennwerts mit einem generierten Zufallswert, um eine randomisierte Periode eines ersten Trägersignals zu bestimmen;
Generieren des ersten Trägersignals mit der randomisierten Periode;
Generieren eines zweiten Trägersignals, das im Verhältnis zum ersten Trägersignal phasenverschoben ist;
Generieren erster Pulsweitenmodulations-(PWM)-Signale, die zum Steuern eines Zustands eines ersten Phasenabschnitts des verschachtelten Leistungswandlers verwendet werden, **durch** Vergleichen des ersten Trägerfrequenzsignals mit einem Referenzsignal;
Generieren zweiter Pulsweitenmodulations-(PWM)-Signale, die zum Steuern eines Zustands eines zweiten Phasenabschnitts des verschachtelten Leistungswandlers verwendet werden, **durch** Vergleichen des zweiten Trägersignals mit dem Referenzsignal; und
Bereitstellen der ersten und zweiten PWM-Signale an den verschachtelten Leistungswandler.

10. Verfahren nach Anspruch 9, wobei die Zufallswerte positive und negative Werte sind, und das Anpassen des Nennwerts mit dem erzeugten Zufallswert das Addieren des generierten Zufallswerts zu dem Nennwert umfasst, um die randomisierte Periode des ersten Trägersignals zu bestimmen.

11. Verfahren nach Anspruch 9, wobei die Periode des ersten Trägersignals einmal pro Halbzyklus des ersten Trägersignals oder einmal pro Zyklus des ersten Trägersignals oder einmal pro mehrere Zyklen des ersten Trägersignals modifiziert wird.

12. Verfahren nach Anspruch 9, 10 oder 11, wobei die ersten und zweiten PWM-Signale jeweils zwei komplementäre PWM-Signale umfassen.

## Revendications

1. Contrôleur pour fournir une commande de modulation de largeur d'impulsion d'un convertisseur de puissance entrelacé ayant au moins une première jambe de phase et une deuxième jambe de phase, le contrôleur **caractérisé par** :
un générateur de valeurs aléatoires (22) qui génère aléatoirement des valeurs ;
un additionneur qui additionne les valeurs générées par le générateur de valeurs aléatoires à une valeur nominale pour définir une période d'un signal porteur ;
un générateur de signal porteur (24) qui génère un premier signal porteur ayant une période définie par la sortie de l'additionneur, dans lequel la période du signal porteur est changée par rapport à une période nominale par l'addition de la valeur aléatoire fournie par le générateur de valeurs aléatoires à la valeur nominale ;
un ajusteur de phase (26, 28) qui génère un deuxième signal porteur déphasé par rapport au premier signal porteur ;
un premier comparateur (32a) qui compare le premier signal porteur à un signal de référence pour générer des premiers signaux modulés en largeur d'impulsion (PWM) utilisés pour commander un état de la première jambe de phase du convertisseur de puissance entrelacé ; et
un deuxième comparateur (32b) qui compare le deuxième signal porteur au signal de référence pour générer des deuxièmes signaux PWM utilisés pour commander un état de la deuxième jambe de phase du convertisseur de puissance entrelacé.

2. Contrôleur selon la revendication 1, dans lequel le générateur de valeurs aléatoires génère aléatoirement des valeurs positives et négatives.

3. Contrôleur selon la revendication 1 ou 2, dans lequel la période du premier signal porteur est modifiée une fois par demi-cycle du premier signal porteur ou une fois par cycle du premier signal porteur ou une fois par multiples cycles du premier signal porteur.

4. Contrôleur selon la revendication 1, 2 ou 3, dans lequel les premiers et deuxièmes signaux PWM comprennent chacun deux signaux PWM complémentaires.

5. Système convertisseur de puissance comprenant :
un convertisseur de puissance entrelacé (12) ayant une pluralité de jambes de phase connectées en parallèle (16) connectées entre des bornes de courant continu (DC) et
une borne de courant alternatif (AC) ;
une pluralité d'inducteurs connectés en parallèle (L1, L2, L3) connectées chacune à une de la pluralité de jambes de phase connectées en parallèle pour fournir une sortie additionnée des jambes de phase connectées en parallèle sur la borne AC ; et
un contrôleur (14) selon une quelconque revendication précédente qui génère des signaux de modulation de largeur d'impulsion (PWM) utilisés pour commander l'état de chacune de la pluralité de jambes de phase en comparant le signal porteur au signal de référence.

6. Système convertisseur de puissance selon la revendication 5, dans lequel la pluralité de jambes de phase connectées en parallèle comprend une première jambe de phase, une deuxième jambe de phase et une troisième jambe de phase.

7. Système convertisseur de puissance selon la revendication 6, dans lequel la pluralité d'inducteurs connectés en parallèle comprend un premier inducteur connecté entre la première jambe de phase et la borne AC, un deuxième inducteur connecté entre la deuxième jambe de phase et la borne AC et une troisième inducteur connecté entre la troisième jambe de phase et la borne AC.

8. Système convertisseur de puissance selon la revendication 7, dans lequel le signal porteur est divisé en un premier signal porteur, un deuxième signal porteur déphasé par rapport au premier signal porteur et un troisième signal porteur déphasé par rapport aux premier et deuxième signaux porteur.

9. Procédé de réduction d'interférence électromagnétique (EMI) d'un convertisseur de puissance entrelacé, le procédé étant **caractérisé par** :
la génération de valeurs aléatoires ;
le réglage périodique d'une valeur nominale avec une valeur aléatoire générée pour déterminer une période randomisée d'un premier signal porteur ;
la génération du premier signal porteur ayant la période randomisée ;
la génération d'un deuxième signal porteur qui est déphasé par rapport au premier signal porteur ;
la génération de premiers signaux de modulation de largeur d'impulsion (PWM) utilisés pour commander un état d'une première jambe de phase du convertisseur de puissance entrelacé en comparant le premier signal porteur à un signal de référence ;
la génération de deuxièmes signaux de modulation de largeur d'impulsion (PWM) utilisés pour commander un état d'une deuxième jambe de phase du convertisseur de puissance entrelacé en comparant le deuxième signal porteur au signal de référence ; et
la fourniture des premiers et deuxièmes signaux PWM au convertisseur de puissance entrelacé.

10. Procédé selon la revendication 9, dans lequel les valeurs aléatoires sont des valeurs positives et négatives, et l'ajustement de la valeur nominale avec la valeur aléatoire générée comprend l'addition de la valeur aléatoire générée à la valeur nominale pour déterminer la période randomisée du premier signal porteur.

11. Procédé selon la revendication 9, dans lequel la période du premier signal porteur est modifiée une fois par demi-cycle du premier signal porteur ou une fois par cycle du premier signal porteur ou une fois par multiples cycles du premier signal porteur.

12. Procédé selon la revendication 9, 10 ou 11, dans lequel les premiers et deuxièmes signaux PWM comprennent chacun deux signaux PWM complémentaires.
